# EUROPÄISCHE PATENTANMELDUNG

(11) **EP 4 181 397 A1**
(43) Veröffentlichungstag der Anmeldung: **17.05.2023**
(21) Anmeldenummer: 22207717.4
(22) Anmeldetag: 16.11.2022
(51) Int. Cl.: H03K 17/955, H03K 17/975

(54) **GRIFFMODUL MIT BETÄTIGUNGSMODUL FÜR EIN ELEKTRONISCHES SCHLIESSSYSTEM UND FAHRZEUGTÜR MIT GRIFFMODUL**

(30) Priorität: 16.11.2021 DE 102021212876
(71) Anmelder: Witte Automotive GmbH, 42551 Velbert (DE)
(72) Erfinder: MENSCH, Reinaldo, 42113 Wuppertal (DE); HÖHN, Ralf, 42549 Velbert (DE); STEINHAUER, Karsten, 45147 Essen (DE)
(74) Vertreter: Liedtke & Partner Patentanwälte

(57) **Zusammenfassung**

Die Erfindung betrifft ein Griffmodul (5), umfassend mindestens ein Betätigungsmodul (4) zum Auslösen einer Schaltfunktion, wobei das Betätigungsmodul (4) als ein kapazitiver Betätigungssensor (6) ausgebildet ist und mindestens:
- zwei oder mehrere kapazitive Hilfselektroden (13) zur Erfassung von Sekundärsignalen,
- eine kapazitive Hauptelektrode (12) zur Erfassung eines Betätigungsweges, und
- eine elektronische Auswerteeinheit (7), welche mit den Hilfselektroden (13) und der Hauptelektrode (12) verbunden ist,
umfasst,
wobei die Auswerteeinheit (7) eingerichtet ist, in Abhängigkeit von den erfassten Signalen der Hilfselektroden (13) und dem erfassten Signal der Hauptelektrode (12) ein Schaltsignal für die Schaltfunktion auszulösen oder zu sperren.

## Beschreibung

Die Erfindung betrifft ein Griffmodul mit einem Betätigungsmodul für ein elektronisches Schließsystem, insbesondere zum Entriegeln, Verriegeln, Öffnen und/oder Schließen des elektronischen Schließsystems, insbesondere eines elektronischen Schlosses eines beweglichen Fahrzeugelements, insbesondere einer Fahrzeugtür. Des Weiteren betrifft die Erfindung eine Fahrzeugtür mit einem solchen Griffmodul mit Betätigungsmodul.

Griffmodule sind beispielsweise bekannt an Fahrzeugtüren, Heckklappen oder Motorhauben. Diese sind üblicherweise mit einem Griffelement versehen, das nach außen geschwenkt werden kann, um die Fahrzeugtür, die Heckklappe oder die Motorhaube öffnen zu können. Griffmodule können dabei elektronische Sensormodule zum Öffnen oder Schließen eines Schlosses der Tür umfassen.

Der Erfindung liegt die Aufgabe zu Grunde, ein gegenüber dem Stand der Technik verbessertes Griffmodul mit einem Betätigungsmodul sowie eine Fahrzeugtür mit einem solchen verbesserten Griffmodul anzugeben.

Die erstgenannte Aufgabe wird erfindungsgemäß durch ein Griffmodul mit den Merkmalen des Anspruchs 1 gelöst. Die zweitgenannte Aufgabe wird erfindungsgemäß durch eine Fahrzeugtür mit den Merkmalen des Anspruchs 10 gelöst.

Vorteilhafte Weiterbildungen der Erfindung sind Gegenstand der abhängigen Patentansprüche.

Das erfindungsgemäße Griffmodul umfasst mindestens ein Betätigungsmodul zum Auslösen einer Schaltfunktion, wobei das Betätigungsmodul als ein, insbesondere kapazitiver, Betätigungssensor ausgebildet ist und mindestens zwei oder mehrere, insbesondere kapazitive, Hilfselektroden zur Erfassung von Sekundärsignalen, eine, insbesondere kapazitive, Hauptelektrode zur Erfassung eines Betätigungsweges und eine elektronische Auswerteeinheit, welche mit den Hilfselektroden und der Hauptelektrode verbunden ist, umfasst, wobei die Auswerteeinheit eingerichtet ist, in Abhängigkeit von den erfassten Signalen der Hilfselektroden und dem erfassten Signal der Hauptelektrode ein Schaltsignal für die Schaltfunktion auszulösen oder zu sperren.

Mittels der Erfindung wird sichergestellt, dass nur dann eine Schaltfunktion ausgelöst wird, wenn auch ein Schalten gewünscht ist. Die Hauptelektrode dient dabei der Erfassung einer gewünschten Betätigung zum Ausführen einer Schaltfunktion. Die Hilfselektroden dienen der Prüfung, ob tatsächlich eine Betätigung erfolgt oder eine Fehlbetätigung vorliegt. Die Hilfselektroden sind beispielsweise als ein kapazitiver Näherungssensor mit geringer Empfindlichkeit oder als ein Sensor zur Messung der elektrischen Feldstärke ausgebildet. Die Hilfselektroden dienen als Kompensationselektrode oder Prüfelektrode, um ein unerwünschtes Schalten beispielsweise aufgrund einer Verschmutzung, Tau, Feuchte, Regen, Schnee oder dergleichen zu verhindern.

Die Hauptelektrode (auch primäre Elektrode genannt) ist beispielsweise als ein kapazitiver Drucksensor oder Betätigungssensor ausgebildet. Die Hauptelektrode detektiert eine mechanische Betätigung. Beispielsweise kann hierzu in einem Abstand zur Hauptelektrode und oberhalb dieser ein bewegliches Metallblech als Gegenelektrode in derselben Größe angeordnet sein. Das Metallblech wird bei einer Betätigung in Richtung der Hauptelektrode bewegt. Ein hieraus resultierendes Signal wird der Auswerteeinheit zugeführt. Die Auswerteeinheit ist eingerichtet, eine Schaltfunktion auszulösen, wenn das Signal der Hauptelektrode einen Betätigungsweg von minimal 0,01 mm und die Signale aller Hilfselektroden keinen Wert oder einen Wert von 1 µm bis 2 µm erfassen. Darüber hinaus kann die Auswerteeinheit eingerichtet sein, eine Schaltfunktion zu sperren, wenn das Signal der Hauptelektrode einen Betätigungsweg von minimal 0,01 mm und die Signale aller Hilfselektroden einen Wert von größer 5 µm erfassen.

Bevorzugt ist das Betätigungsmodul als ein metal-over-capacitive-Berührungssensormodul (kurz MOC-Sensor genannt) ausgebildet.

Beispielsweise sind die Hilfselektroden und die Hauptelektrode als Metallflächen auf einer Leiterplatte des Griffmoduls angeordnet. Die Hilfselektroden als kapazitive Näherungssensoren können beispielsweise als Plattenkondensatoren auf der Leiterplatte angeordnet sein. Die Hilfselektroden als E-Feld-Messer können beispielsweise als zwei Metallelektroden auf der Leiterplatte angeordnet sein. Elektrische Felder erzeugen Mikroströme zwischen den Metallelektroden, die gemessen und der Auswerteeinheit zugeführt werden. Die Hilfselektroden als kapazitiver Näherungssensor können beispielsweise als eine aktive Sensorelektrode mit einem aktiven elektrischen Feld ausgebildet sein, wobei eine elektrische Kapazität des elektrischen Feldes (Änderung des elektrischen Feldes) zwischen der Sensorelektrode und einem Gegenpotential, zum Beispiel einer Hand eines sich nähernden Nutzers oder einfallendes Regenwasser oder einfallender Schnee, erfasst wird.

Die Hauptelektrode als kapazitiver Drucksensor umfasst beispielsweise eine ortsfeste Metallfläche auf der Leiterplatte und ein bewegliches Betätigungselement (auch bewegliches Sensorelement oder Metallblech genannt). Das bewegliche Betätigungselement ist der Hauptelektrode, insbesondere der ortsfesten Metallfläche, gegenüberliegend und beabstandet zu dieser angeordnet. Beispielsweise ist das bewegliche Betätigungselement als ein Federblech oder Metallblech ausgebildet. Das Metallblech weist bevorzugt dieselbe Größe wie die Hauptelektrode auf.

Das Betätigungsmodul kann auf einer Griffinnenseite oder Griffaußenseite des Griffmoduls angeordnet sein. Das Griffmodul ist beispielsweise als ein Türaußengriffmodul ausgebildet.

Das Betätigungsmodul für ein elektronisches Schließsystem umfasst zumindest einen kapazitiven Betätigungssensor, insbesondere einen kraftgesteuerten kapazitiven Betätigungssensor (auch Hauptelektrode oder Primärelektrode genannt), zum Ausführen einer Schaltfunktion, zum Beispiel zum Entriegeln und Öffnen des elektronischen Schließsystems, und eine elektronische Auswerteeinheit, welche mit dem kapazitiven Betätigungssensor verbunden ist, wobei mittels der elektronischen Auswerteeinheit anhand einer erfassten Kapazitätsveränderung des kapazitiven Betätigungssensors ein Betätigungsweg eines Betätigungselements oder Auslöseelements ermittelbar ist, wobei der kapazitive Betätigungssensor und die Auswerteeinheit derart eingerichtet sind, dass bei einem ermittelten Betätigungsweg von kleiner 0,5 mm, insbesondere in einem Bereich von 0,01 mm bis 0,4 mm, zum Beispiel von 0,01 mm bis 0,2 mm, ein Auslösesignal zum Ausführen der Schaltfunktion generiert wird.

Insbesondere sind der kapazitive Betätigungssensor und die elektronische Auswerteeinheit derart eingerichtet, dass ein minimaler Betätigungsweg oder Auslöseweg von 0,01 mm oder größer, insbesondere in einem Bereich von 0,01 mm bis 0,5 mm, insbesondere von 0,01 mm bis 0,4 mm oder 0,01 mm bis 0,2 mm, erfassbar ist.

Beispielsweise werden die Messwerte für die Kapazitätsveränderung mit einer solchen Auflösung erfasst und mittels der Auswerteeinheit verarbeitet, dass ein minimaler Betätigungsweg oder Auslöseweg von 0,01 mm oder größer, maximal von 0,4 mm, erfassbar ist.

Hierzu umfasst die elektronische Auswerteeinheit einen Analog-Digital-Wandler und einen Mikroprozessor, wobei der Analog-Digital-Wandler zur Umwandlung der erfassten Kapazitätsveränderungen in Digitalwerte und der Mikroprozessor zur Verarbeitung der Digitalwerte und zur Erzeugung des Auslösesignals vorgesehen ist.

Bevorzugt ist der Analog-Digital-Wandler als ein 16-Bit-Wandler, ein 24-Bit-Wandler oder 32-Bit-Wandler ausgebildet. Hierdurch können geringe Verformungen des Betätigungssensors und daraus resultierend geringe Kapazitätsveränderung und daraus resultierend geringe Betätigungswege oder Auslösewege erfasst werden, wobei eine Verformung des Betätigungselements oder Auslöseelements von 0,01 mm (= Betätigungs- oder Auslösehub) erfasst und somit bereits bei einer erfassten Verformung von 0,01 mm ein Auslösesignal erzeugbar ist.

In einer möglichen Ausführungsform umfasst der kapazitive Betätigungssensor mehrere Elektroden, insbesondere Flächenelektroden, die zueinander ausgerichtet und voneinander beabstandet angeordnet sind.

Jede Elektrode weist insbesondere eine vorgegebene Kapazität auf und ist mit der Auswerteeinheit verbunden, welche Änderungen in der Kapazität der jeweiligen Elektrode erfasst. Eine der Elektroden ist eine Hauptelektrode und die anderen Elektroden sind Hilfselektroden.

Die Auswerteeinheit ist insbesondere eingerichtet, alle Elektroden gemeinsam zu überwachen derart, dass Änderungen der Kapazitäten der mehreren Hilfselektroden und Änderungen der Kapazität der Hauptelektrode erfasst und miteinander verglichen und/oder mit vorgegebenen Referenzwerten verglichen werden. In Abhängigkeit von den erfassten Signalen wird mittels der Auswerteeinheit eine Schaltfunktion ausgelöst (oder freigegebenen) oder gesperrt.

Insbesondere ist das Betätigungsmodul als ein sogenanntes MOC-Modul ausgebildet (= metall-over-cap-Modul), bei welchem die innen liegenden metallischen Sensorkomponenten, insbesondere die Elektroden, des kapazitiven Betätigungssensors nach außen hin gekapselt sind.

Das Betätigungsmodul ist dabei in einem Griffmodul eines beweglichen Fahrzeugelements, wie einer Tür oder Heckklappe, angeordnet.

Die Erfindung ermöglicht einen kompakten Aufbau des Griffmoduls und kleine Betätigungshübe, insbesondere von kleiner 0,4 mm, zum Beispiel in einem Bereich von 0,01 mm bis 0,3 mm, des Betätigungsmoduls. Darüber hinaus sind die Betätigungskräfte einstellbar, insbesondere sind Schwellenwerte vorgebbar. Bedingt durch die Erfassung von Betätigungshüben von kleiner 0,4 mm kann das Betätigungsmodul auf ein Ausschäumen oder Elastomer verzichten.

Ausführungsbeispiele der Erfindung werden anhand von Zeichnungen näher erläutert. Dabei zeigen:
- Figur 1: in perspektivischer Darstellung ein Fahrzeug mit einem außenseitig angeordneten Griffmodul mit integriertem Betätigungsmodul,
- Figur 2: eine schematische Darstellung eines ersten Ausführungsbeispiels für ein Betätigungsmodul,
- Figur 3: schematisch ein Griffmodul mit integriertem Betätigungsmodul gemäß Figur 2,
- Figur 4: eine schematische Darstellung eines zweiten Ausführungsbeispiels für ein Betätigungsmodul,
- Figur 5: eine weitere schematische Darstellung des zweiten Ausführungsbeispiels für das Betätigungsmodul gemäß Figur 4,
- Figur 6: schematisch ein Griffmodul mit dem integrierten Betätigungsmodul gemäß Figuren 4 und 5, und
- Figur 7: eine schematische Darstellung eines Griffmoduls als Türaußengriffmodul mit integriertem Betätigungsmodul.

Einander entsprechende Teile sind in allen Figuren mit den gleichen Bezugszeichen versehen.

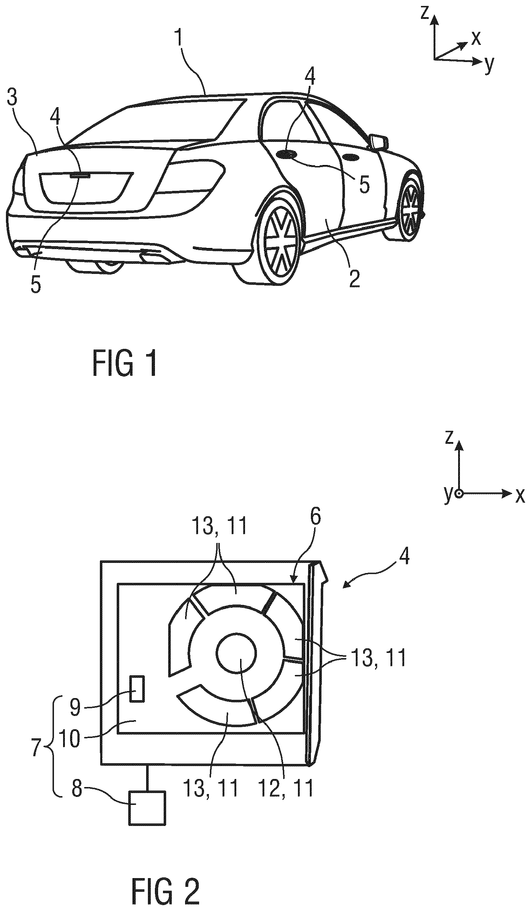

Figur 1 zeigt schematisch ein Fahrzeug 1. Das Fahrzeug 1 weist auf seiner Außenseite mehrere elektronisch schaltbare Bereiche auf. Beispielsweise weist das Fahrzeug 1 im Bereich einer Tür 2 oder einer Heckklappe 3 jeweils ein Griffmodul 5 mit einem integrierten Betätigungsmodul 4 für ein elektronisches Schließsystem, insbesondere zum Entriegeln, Verriegeln, Öffnen und/oder Schließen des elektronischen Schließsystems, insbesondere eines elektronischen Schlosses, der Tür 2 oder der Heckklappe 3 auf. Insbesondere dient das Betätigungsmodul 4 dem Erfassen mindestens einer manuellen Betätigung des Griffmoduls 5 durch eine Hand eines Nutzers.

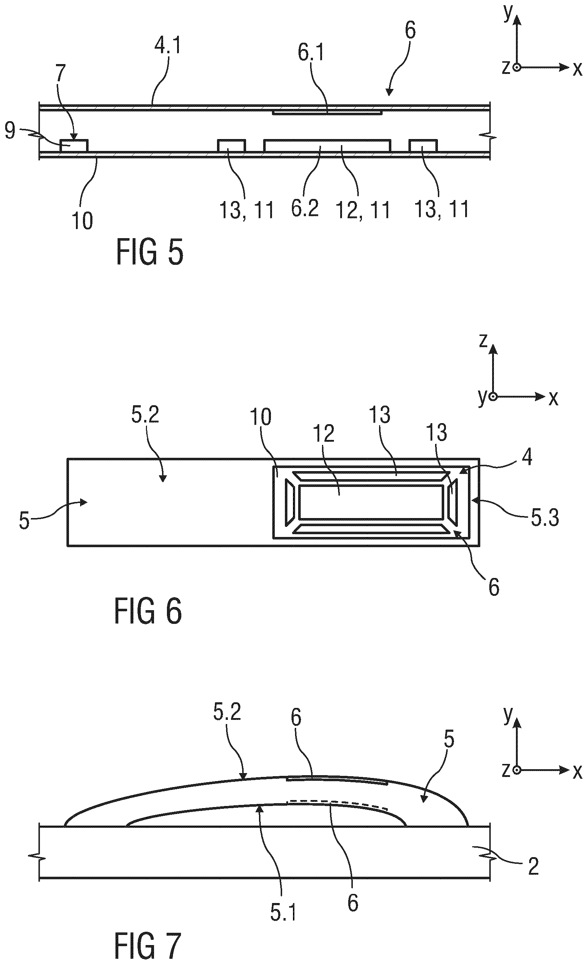

Das Betätigungsmodul 4 kann in dem Griffmodul 5 der Tür 2 oder der Heckklappe 3 angeordnet, insbesondere integriert, sein. Das Griffmodul 5 ist beispielsweise ein Außengriffmodul. Das Betätigungsmodul 4 kann auf einer Griffinnenseite 5.1 und/oder einer Griffaußenseite 5.2 des Griffmoduls 5 (dargestellt in Figur 7) integriert sein.

Das Betätigungsmodul 4 ermöglicht in einfacher Art und Weise das Aktivieren einer entsprechenden Funktion des Fahrzeugs 1, wie beispielsweise Öffnen oder Schließen der Tür 2, Entriegeln oder Verriegeln eines Heckklappenschlosses oder Frontklappenschlosses, Öffnen oder Schließen der Heckklappe 3. Hierzu kann das Fahrzeug 1 mit mehreren Betätigungsmodulen 4 ausgestattet sein. Dabei können je Griffmodul 5 mindestens ein oder mehrere Betätigungsmodule 4 vorgesehen und integriert sein.

Figur 2 zeigt eine schematische Darstellung eines ersten Ausführungsbeispiels für das Betätigungsmodul 4.

Das Betätigungsmodul 4 umfasst zumindest einen kapazitiven Betätigungssensor 6, insbesondere einen kraftgesteuerten kapazitiven Betätigungssensor 6, zum Ausführen der Schaltfunktion, zum Beispiel zum Entriegeln und Öffnen des elektronischen Schließsystems.

Das Betätigungsmodul 4 umfasst darüber hinaus eine elektronische Auswerteeinheit 7 (auch Elektronikeinheit genannt).

Die elektronische Auswerteeinheit 7 ist mit dem kapazitiven Betätigungssensor 6 zumindest signaltechnisch verbunden. Dabei ist mittels der elektronischen Auswerteeinheit 7 anhand einer erfassten Kapazitätsveränderung des kapazitiven Betätigungssensors 6 ein Betätigungsweg eines Betätigungselements oder Auslöseelements (auch bewegliches Sensorelement 6.1 genannt), insbesondere ein durch Druck der Hand des Nutzers auf das Betätigungsmodul 4 zurückgelegter Betätigungsweg, ermittelbar.

Der kapazitive Betätigungssensor 6 und die elektronische Auswerteeinheit 7 sind derart eingerichtet, dass bei einem ermittelten Betätigungsweg von kleiner 0,5 mm, insbesondere in einem Bereich von 0,01 mm bis 0,4 mm, zum Beispiel von 0,01 mm bis 0,2 mm, ein Auslösesignal zum Ausführen einer Funktion des Fahrzeugs 1, insbesondere einer Schaltfunktion des elektronischen Schließsystems, zum Beispiel ein Auslösesignal zum Entriegeln und Öffnen des elektronischen Schließsystems, generiert wird.

Insbesondere sind der kapazitive Betätigungssensor 6 und die elektronische Auswerteeinheit 7 derart eingerichtet, dass ein minimaler Betätigungsweg oder Auslöseweg von 0,01 mm oder größer, insbesondere in einem Bereich von 0,01 mm bis 0,5 mm, insbesondere von 0,01 mm bis 0,4 mm oder 0,01 mm bis 0,2 mm, erfassbar ist.

Beispielsweise werden die Messwerte für die Kapazitätsveränderung mit einer solchen Auflösung erfasst und mittels der elektronischen Auswerteeinheit 7 verarbeitet, dass ein minimaler Betätigungsweg oder Auslöseweg von 0,01 mm oder größer, maximal von 0,4 mm, ermittelbar ist.

Hierzu umfasst die elektronische Auswerteeinheit 7 einen Analog-Digital-Wandler 8 und einen Mikroprozessor 9.

Der Mikroprozessor 9 ist dabei Teil einer Leiterplatte 10, die im Betätigungsmodul 4 angeordnet ist.

Der Analog-Digital-Wandler 8 ist für eine hohe Auflösung als ein 16-Bit-Wandler, 24-Bit-Wandler oder 32-Bit-Wandler ausgeführt und außerhalb des Betätigungsmoduls 4 angeordnet. Der im Betätigungsmodul 4 angeordnete Betätigungssensor 6 und der Mikroprozessor 9 sind mit dem externen Analog-Digital-Wandler 8 verbunden. Der Analog-Digital-Wandler 8 ist beispielsweise im Griffmodul 5 oder in Nähe des Betätigungsmoduls 4, insbesondere angrenzend zu diesem angeordnet.

Je nach Größe des Analog-Digital-Wandlers 8 kann dieser auch im Betätigungsmodul 4 auf der Leiterplatte 10 angeordnet sein.

Der Analog-Digital-Wandler 8 ist zur Umwandlung der erfassten Kapazitätsveränderungen in Digitalwerte und der Mikroprozessor 9 zur Verarbeitung der Digitalwerte und zur Erzeugung des Auslösesignals für die Funktion, insbesondere eine Schaltfunktion, vorgesehen.

Durch die Ausbildung des Analog-Digital-Wandlers 8 als ein Wandler mit hoher Auflösung können geringe Verformungen des Betätigungselements oder Auslöseelements anhand der mit hoher Auflösung erfassten geringen Kapazitätsveränderungen des kapazitiven Betätigungssensors 6 und daraus resultierend geringe Betätigungswege oder Auslösewege bestimmt werden. Dabei kann bereits eine Verformung des Betätigungselements oder Auslöseelements des Betätigungsmoduls 4 von 0,01 mm (= Betätigungs- oder Auslösehub) erfasst und somit bereits bei einer erfassten Verformung von 0,01 mm ein Auslösesignal mittels der elektronischen Auswerteeinheit 7, insbesondere mittels Algorithmen des Mikroprozessors 9, erzeugt werden.

In einer möglichen Ausführungsform umfasst der kapazitive Betätigungssensor 6 mehrere Elektroden 11, insbesondere Flächenelektroden, die zueinander ausgerichtet und voneinander beabstandet angeordnet sind.

Jede Elektrode 11 weist insbesondere eine vorgegebene Kapazität auf und ist mit der elektronischen Auswerteeinheit 7 verbunden, welche Änderungen in der Kapazität der jeweiligen Elektrode 11 erfasst. Eine der Elektroden 11 ist eine Hauptelektrode 12 und die anderen Elektroden 11 sind Hilfselektroden 13.

Die Hauptelektrode 12 dient der Bestimmung des Betätigungsweges oder Auslöseweges anhand von erfassten Kapazitätsveränderungen.

Die Hilfselektroden 13 (auch Sicherheitselektroden genannt) dienen der Ermittlung von Umwelteinflüssen, wie zum Beispiel Regen, Schnee, Hagel, anhand von erfassten Kapazitätsveränderungen.

Die elektronische Auswerteeinheit 7 ist insbesondere eingerichtet, alle Elektroden 11 gemeinsam zu überwachen derart, dass Änderungen der Kapazitäten der mehreren Hilfselektroden 13, zum Beispiel aufgrund von Annäherung und/oder Beaufschlagung durch Schmutz, Feuchte, Regen, Schnee oder dergleichen, und Änderungen der Kapazität der Hauptelektrode 12, zum Beispiel aufgrund von Berührung und/oder Betätigung im Millimeterbereich, erfasst und miteinander verglichen und/oder mit vorgegebenen Referenzwerten verglichen werden.

Für eine sichere Auslösung oder ein sicheres Sperren einer Schaltfunktion, wie einer Entriegelungsfunktion oder Verriegelungsfunktion, bei einer identifizierten Berührung des Betätigungsmoduls 4 mittels eines Betätigungselements im Bereich der Hauptelektrode 12 wird mittels der Hilfselektroden 13 die Umgebung der Hauptelektrode 12 überwacht.

Bei einer sicheren Erkennung einer Berührung der Hauptelektrode 12 wird dann beispielsweise mittels der Auswerteeinheit 7 ein Steuersignal ausgelöst, dass eine entsprechende Funktion, wie eine Schließfunktion, Öffnungsfunktion, Entriegelungsfunktion oder Verriegelungsfunktion, steuert, beispielsweise auslöst oder sperrt.

Hierbei ist die Auswerteeinheit 7 eingerichtet, in Abhängigkeit von den ermittelten Änderungen der Kapazität der Hauptelektrode 12 und/oder Hilfselektroden 13 ein Schaltsignal oder Steuersignal auszulösen oder eine solche Auslösung eines Schalt- oder Steuersignals zu sperren.

Im ersten Ausführungsbeispiel umfasst der kapazitive Betätigungssensor 6 die kapazitive Hauptelektrode 12 und die mehreren Hilfselektroden 13. Die zwei oder mehreren kapazitiven Hilfselektroden 13 erfassen Sekundärsignale. Die kapazitive Hauptelektrode 12 erfasst als Primärsignal den Betätigungsweg. Sowohl die Hauptelektrode 12 als auch die Hilfselektroden 13 sind mit der Auswerteeinheit 7 verbunden. Die Auswerteeinheit 7 ist eingerichtet, in Abhängigkeit von den erfassten Signalen der Hilfselektroden 13 und dem erfassten Signal der Hauptelektrode 12 ein Schaltsignal für eine Schaltfunktion auszulösen oder zu sperren.

Beispielsweise ist die Auswerteeinheit 7 eingerichtet, eine Schaltfunktion auszulösen, wenn das Signal der Hauptelektrode 12 einen Betätigungsweg von minimal 0,01 mm und die Signale aller Hilfselektroden 13 keinen Wert oder einen Wert von 1 µm bis 2 µm erfassen.

Zusätzlich kann die Auswerteeinheit 7 eingerichtet sein, eine Schaltfunktion zu sperren, wenn das Signal der Hauptelektrode 12 einen Betätigungsweg von minimal 0,01 mm und die Signale aller Hilfselektroden 13 einen Wert von größer 5 µm erfassen.

Beispielsweise kann die Auswerteeinheit 7 als Algorithmen des Mikroprozessors 9 auf der Leiterplatte 10 implementiert sein.

Die Elektroden 11 sind insbesondere Flächenelektroden, zum Beispiel Streifenelektroden, Kreiselektroden und/oder Rechteckelektroden. Beispielsweise weisen die Hilfselektroden 13 größere Abmessungen als die Hauptelektrode 12 auf.

Die Hilfselektroden 13 sind im Ausführungsbeispiel als bogenförmige Streifenelektroden ausgebildet. Die Hilfselektroden 13 können aber auch eine andere geeignete Form aufweisen.

Die Hilfselektroden 13 sind jeweils benachbart zur Hauptelektrode 12 angeordnet, insbesondere in einem Kreis verteilt um die Hauptelektrode 12 herum und in einem Abstand zu dieser angeordnet.

Die Hilfselektroden 13 dienen insbesondere der Überwachung der Umgebung der Hauptelektrode 12. Beispielsweise werden mittels der Hilfselektroden 13 Fehlsignale, die beispielsweise durch eine Einwirkung, insbesondere eine mechanische Beanspruchung oder Beaufschlagung mit Staub, Regen oder Schmutz, verursacht sind, erkannt und eine Fehlauslösung unterdrückt, indem eine Auslösung der Funktion infolge einer detektierten Betätigung der Hauptelektrode 12 mit dem minimalen Betätigungshub von 0,01 mm oder größer, gesperrt oder unterdrückt wird.

Darüber hinaus kann das Betätigungsmodul 4 als ein sogenanntes MOC-Modul (= metall-over-cap-Modul) ausgebildet sein, bei welchem die innen liegenden metallischen Sensorkomponenten, insbesondere die Elektroden 11, und damit der kapazitive Betätigungssensor 6 nach außen hin gekapselt sind.

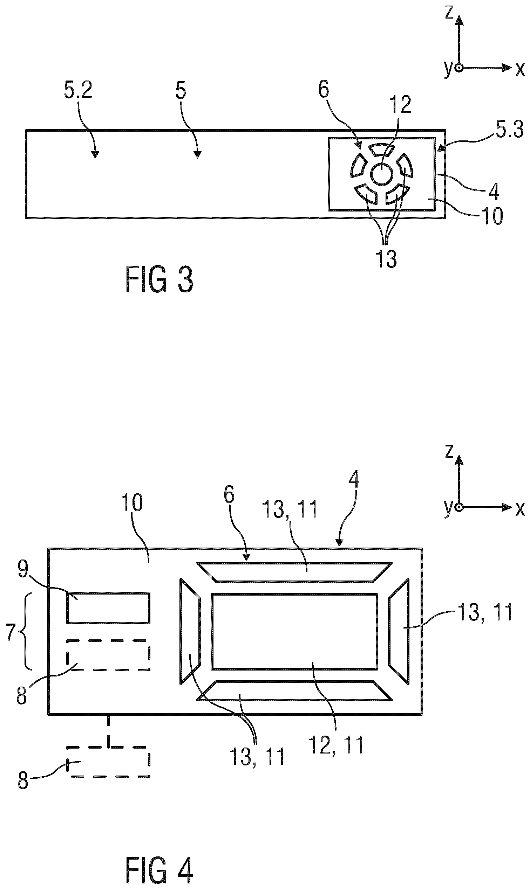

Der Betätigungssensor 6 des Betätigungsmoduls 4 wird im eingebauten Zustand im Griffmodul 5 oder an einem anderen geeigneten Bauteil der Tür 2 oder der Heckklappe 3 durch Kraft beaufschlagt, zum Beispiel durch eine Druckkraft an einer Griffaußenseite 5.2 (dargestellt in Figuren 3 und 7).

Figur 3 zeigt beispielsweise in Draufsicht das Griffmodul 5. Das Betätigungsmodul 4 mit seinem Betätigungssensor 6 mit der Hauptelektrode 12 und den Hilfselektroden 13 ist auf der Leiterplatte 10 integriert, die beispielsweise auf einer der Oberflächenseiten, zum Beispiel der Griffaußenseite 5.2 des Griffmoduls 5 an einem Längsende 5.3 integriert ist.

Figur 4 zeigt ein zweites Ausführungsbeispiel für das Betätigungsmodul 4 mit einer mittigen Hauptelektrode 12 und den um diese verteilt angeordneten Hilfselektroden 13 als Betätigungssensor 6. Anstelle von kreisförmigen Elektroden 11 sind die als Flächenelektroden ausgebildeten Elektroden 11 des zweiten Ausführungsbeispiels eckig ausgebildet. Beispielsweise ist die Hauptelektrode 12 rechteckig ausgebildet. Die Hilfselektroden 13 sind trapezförmig ausgebildet und um die Hauptelektrode 12 verteilt angeordnet. Die Elektroden 11 sind auf der Leiterplatte 10 angeordnet und integriert. Die Elektroden 11 sind mit der elektronischen Auswerteeinheit 7, insbesondere signaltechnisch, verbunden. Die Auswerteeinheit 7 kann den Analog-Digital-Wandler 8 umfassen. Dieser Analog-Digital-Wandler 8 kann Teil der Leiterplatte 10 oder einer anderen elektronischen Einheit der Tür 2 des Fahrzeugs 1 sein.

Die Funktionsweise des Betätigungssensors 6 gemäß des ersten und zweiten Ausführungsbeispiels ist identisch. Die Betätigungssensoren 6 unterscheiden sich nur in der Anzahl und der Form der Hilfselektroden 13 und der Hauptelektrode 12.

Die nachfolgende Funktionsweise gilt für beide Ausführungsbeispiele.

Beispielsweise wird mittels der Hauptelektrode 12 eine Kapazitätsänderung aufgrund eines Betätigungshubs erfasst. Übersteigt die Kraft einen vorgegebenen Schwellwert von beispielsweise 0,01 mm, wird dies als ein Öffnungswunsch identifiziert und das Türschloss sicher entriegelt.

Die Auslösung der Entriegelung kann zum Beispiel anschließend durch Drücken des Griffmoduls 5 an der Griffaußenseite 5.2 gegen eine Betätigungsfläche des Betätigungsmoduls 4 in Richtung der Fahrzeugkarosserie, so dass die Betätigungsfläche von außen ins Griffinnere gedrückt wird, oder alternativ der Griffinnenseite 5.1 gegen eine Betätigungsfläche des Betätigungsmoduls 4 weg von der Fahrzeugkarosserie erfolgen, so dass die Betätigungsfläche von innen ins Griffinnere gedrückt wird.

Figur 5 zeigt den Betätigungssensor 6 im Schnittbild. Die Auswerteeinheit 7 mit dem Mikroprozessor 9 und die Hilfselektroden 13 sowie die feste Elektrode 11 der Hauptelektrode 12 sind auf der Leiterplatte 10 angeordnet, insbesondere gelötet.

Bei einem hinreichend großen Betätigungshub oder Auslöseweg in das Griffinnere von der Griffaußenseite 5.2 und/oder der Griffinnenseite 5.1 nimmt die Betätigungsfläche ein bewegliches Sensorelement 6.1 (auch Betätigungselement oder Auslöseelement genannt, in Figur 5 näher dargestellt), insbesondere ein Federblech oder eine Metallfeder, mit und drückt dieses ebenfalls in das Griffinnere. Dadurch wird der Abstand zu einem festen Sensorelement 6.2, den Elektroden 11, insbesondere der Hauptelektrode 12, zum Beispiel einer Metallschicht, zum Beispiel einer Kupferschicht auf einer Oberflächenseite der Leiterplatte 10 der Auswerteeinheit 7, verändert und bei Überschreiten eines vorgegebenen Schwellwertes wird als Auslösesignal ein Öffnungssignal von der Auswerteeinheit 7 erzeugt und beispielsweise das Türschloss entriegelt oder eine Türbewegung gestoppt.

Das feste Sensorelement 6.2, insbesondere die Elektroden 11, kann oder können beispielsweise direkt auf einer Oberflächenseite der Leiterplatte 10 oder Elektronik der Auswerteeinheit 7 angeordnet sein. Das bewegliche Sensorelement 6.1, insbesondere ein Betätigungselement oder Auslöseelement (in Figur 5 näher dargestellt), kann in einer Aufnahmeöffnung eines Modulgehäuses 4.1 des Betätigungsmoduls 4 angeordnet sein. Dabei ist das bewegliche Sensorelement 6.1 insbesondere in einem Abstand zum festen Sensorelement 6.2, den Elektroden 11, angeordnet. Das Modulgehäuse 4.1 und das bewegliche Sensorelement 6.1 kapseln dabei das innen liegende feste Sensorelement 6.2, die Elektroden 11, nach außen hin ab. Das Sensorgehäuse oder Modulgehäuse 4.1 ist insbesondere ein Kunststoffgehäuse und kann an die Leiterplatte 10 oder Elektronik angeformt, insbesondere angespritzt sein.

Figur 6 zeigt schematisch das Griffmodul 5 mit dem integrierten Betätigungsmodul 4 gemäß Figuren 4 und 5. Figur 5 zeigt beispielsweise das Griffmodul 5 in Draufsicht. Das Betätigungsmodul 4 mit seinem Betätigungssensor 6 mit der Hauptelektrode 12 und den Hilfselektroden 13 ist auf der Leiterplatte 10 integriert, die beispielsweise auf einer der Oberflächenseiten, zum Beispiel der Griffaußenseite 5.2 des Griffmoduls 5 an einem Längsende 5.3 integriert ist.

Figur 7 zeigt eine schematische Darstellung des Griffmoduls 5 als Türaußengriffmodul mit integriertem Betätigungsmodul 4. Das Griffmodul 5 ist bogenförmig ausgebildet und umfasst die Griffinnenseite 5.1 und die Griffaußenseite 5.2. Der Betätigungssensor 6 kann oberflächenseitig auf der Griffinnenseite 5.1 und/oder der Griffaußenseite 5.2 implementiert sein.

Die Erfindung ermöglicht einen kompakten Aufbau des Betätigungsmoduls 4 und kleine Betätigungshübe, insbesondere von kleiner 0,4 mm, zum Beispiel in einem Bereich von 0,01 mm bis 0,3 mm. Darüber hinaus sind die Betätigungskräfte einstellbar, insbesondere sind Schwellenwerte vorgebbar. Bedingt durch die Erfassung von Betätigungshüben von kleiner 0,4 mm kann das Betätigungsmodul 4 eine besondere geringe Bauhöhe aufweisen, so dass auf ein Ausschäumen oder Elastomer verzichtet werden kann.

### BEZUGSZEICHENLISTE

- 1: Fahrzeug
- 2: Tür
- 3: Heckklappe
- 4: Betätigungsmodul
- 4.1: Modulgehäuse
- 5: Griffmodul
- 5.1: Griffinnenseite
- 5.2: Griffaußenseite
- 5.3: Längsende
- 6: Betätigungssensor
- 6.1: bewegliches Sensorelement
- 6.2: festes Sensorelement
- 7: elektronische Auswerteeinheit
- 8: Analog-Digital-Wandler
- 9: Mikroprozessor
- 10: Leiterplatte
- 11: Elektrode
- 12: Hauptelektrode
- 13: Hilfselektrode

## Patentansprüche

1. Griffmodul (5), umfassend mindestens ein Betätigungsmodul (4) zum Auslösen einer Schaltfunktion, wobei das Betätigungsmodul (4) als ein kapazitiver Betätigungssensor (6) ausgebildet ist und mindestens:
- zwei oder mehrere Hilfselektroden (13) zur Erfassung von Sekundärsignalen,
- eine Hauptelektrode (12) zur Erfassung eines Betätigungsweges, und
- eine elektronische Auswerteeinheit (7), welche mit den Hilfselektroden (13) und der Hauptelektrode (12) verbunden ist,
umfasst,
wobei die Auswerteeinheit (7) eingerichtet ist, in Abhängigkeit von den erfassten Signalen der Hilfselektroden (13) und dem erfassten Signal der Hauptelektrode (12) ein Schaltsignal für die Schaltfunktion auszulösen oder zu sperren.

2. Griffmodul (5) nach Anspruch 1, wobei die Auswerteeinheit (7) eingerichtet ist, eine Schaltfunktion auszulösen, wenn das Signal der Hauptelektrode (12) einen Betätigungsweg von minimal 0,01 mm und die Signale aller Hilfselektroden (13) keinen Wert erfassen.

3. Griffmodul (5) nach Anspruch 1 oder 2, wobei die Auswerteeinheit (7) eingerichtet ist, eine Schaltfunktion zu sperren, wenn das Signal der Hauptelektrode (12) einen Betätigungsweg von minimal 0,01 mm und die Signale aller Hilfselektroden (13) einen Wert von größer 5 µm erfassen.

4. Griffmodul (5) nach einem der vorhergehenden Ansprüche, wobei das Betätigungsmodul (4) als ein metal-over-capacitive-Berührungssensormodul ausgebildet ist.

5. Griffmodul (5) nach einem der vorhergehenden Ansprüche, wobei die Hilfselektroden (13) und die Hauptelektrode (12) als Metallflächen auf einer Leiterplatte (10) angeordnet sind.

6. Griffmodul (5) nach einem der vorhergehenden Ansprüche, wobei ein bewegliches Sensorelement (6.1) vorgesehen ist, das der Hauptelektrode (12) gegenüberliegend und beabstandet zu dieser angeordnet ist.

7. Griffmodul (5) nach Anspruch 6, wobei das bewegliche Sensorelement (6.1) als ein Federblech oder Metallblech ausgebildet ist.

8. Griffmodul (5) nach einem der vorhergehenden Ansprüche, wobei das Betätigungsmodul (4) auf einer Griffinnenseite (5.1) und/oder Griffaußenseite (5.2) angeordnet ist.

9. Griffmodul (5) nach einem der vorhergehenden Ansprüche, ausgebildet als ein Türaußengriffmodul.

10. Tür (2), insbesondere Fahrzeugtür, mit einem Griffmodul (5) nach einem der vorhergehenden Ansprüche.
